# FASCICULE DE BREVET EUROPEEN

(11) **EP 0 622 744 B1**
(45) Date de publication et mention de la délivrance du brevet: **21.06.1995**
(21) Numéro de dépôt: 94400601.4
(22) Date de dépôt: 18.03.1994
(51) Int. Cl.: G06F 17/50

(54) **Procédé et dispositif de détermination de la composition d'un circuit intégré**
Verfahren und System zur Bestimmung der Zusammensetzung einer integrierten Schaltung
Method and system for determining the composition of an integrated circuit

(30) Priorité: 29.04.1993 FR 9305082
(43) Date de publication de la demande: 02.11.1994
(73) Titulaire: SGS-THOMSON MICROELECTRONICS S.A., 94250 Gentilly (FR)
(72) Inventeur: Le Van Suu, Maurice, F-75116 Paris (FR)
(74) Mandataire: Schmit, Christian Norbert Marie

(56) Documents cités:
- MICROPROCESSING AND MICROPROGRAMMING, vol.24, no.1-5, 29 Août 1988, NORTH-HOLLAND pages 299- - 306 RAMMING ET AL 'a transputer-based accelerator for multilevel digital simulation'
- PROCEEDINGS OF THE 1989 INTERNATIONAL CONFERENCE ON PARALLEL PROCESSING, 8 Août 1989, US pages 68 - 72 KUMAR ET AL 'trace driven simulation for studying mimd parallel computers'
- MICROPROCESSING AND MICROPROGRAMMING, vol.24, no.1-5, Août 1988, NORTH-HOLLAND pages 291 - 298 HAHN ET AL 'a multi-transputer-net as a hardware simulation environment'
- PROCEEDINGS OF THE 1986 INTERNATIONAL CONFERENCE ON PARALLEL PROCESSING, 19 Août 1986, US pages 909 - 916 DUBOIS ET AL 'trace-driven simulations of parallel and distributed algorithms in multiprocessors'

## Description

La présente invention a pour objet un procédé et un dispositif de détermination de la composition d'un circuit intégré. Elle concerne principalement les circuits intégrés spécifiques (ASIC : Application Specific for Integrated Circuit dans la littérature anglo-saxonne) munis d'une unité arithmétique et/ou logique, d'une mémoire programme et d'un ou de plusieurs registres de travail. Le but le l'invention est de pouvoir fabriquer de tels circuits intégrés à destination spécifique, plus simples, et dont le coût résultant de cette spécificité serait inférieur à un circuit de type universel plus puissant. L'invention vise en plus à rendre la conception de ces circuits intégrés automatique.

Dans les utilisations actuelles, l'ingénieur en charge de l'automatisation d'un système à commande électronique a essentiellement deux options à sa disposition. Soit il décide de réaliser un circuit câblé intégrant toutes les fonctions logiques, soit il s'oriente vers la réalisation d'un système à microprocesseur comportant dans son principe une unité arithmétique et logique, une mémoire programme et des registres de travail. La dernière approche tend à se généraliser bien que dans certains cas elle ne soit pas toujours indispensable. Cependant, la mise en oeuvre de cette deuxième technique présente des inconvénients fondamentaux.

Pour réaliser une application avec un système à microprocesseur le concepteur est obligé préalablement de choisir le type du microprocesseur avec lequel il voudra travailler. Il choisit donc parmi les différents microprocesseurs disponibles sur le marché celui des microprocesseurs qui lui semble le plus adapté à son besoin. Dans la pratique, on constate qu'il choisit essentiellement celui qu'il connaît le mieux sans que ce circuit soit particulièrement adapté au besoin. Avec l'aide des spécifications du circuit intégré concerné il bâtit son application : c'est-à-dire un programme qui va être en définitive chargé en mémoire programme de ce circuit à microprocesseur et qui va en conditionner le fonctionnement.

Quand une gamme de microprocesseurs existe, la tentation est forte de choisir, pour toute application, le plus puissant de cette gamme de façon à être sûr de pouvoir réaliser toutes les fonctions envisagées dans l'application. Evidemment le circuit le plus puissant est aussi le plus cher, et un tel raisonnement simpliste n'est pas envisageable lorsque l'application est destinée à être mise en oeuvre dans de très nombreux appareils. On imagine par exemple, dans le domaine automobile, qu'un microprocesseur qui serait monté sur une lampe de clignotant d'une voiture devrait être des plus simplifiés pour être très peu cher.

Dans ce cas, le concepteur chargé de la détermination du circuit spécifique risque, s'il choisit un microprocesseur trop puissant d'arriver à un produit trop cher, et s'il choisit un microprocesseur pas assez puissant de devoir recommencer à plusieurs reprises la définition de son circuit jusqu'à ce qu'il soit tombé sur le bon. En outre, dans une famille de microprocesseurs, il est possible que certaines spécificités de la famille soient antinomiques d'un fonctionnement recherché du futur circuit à concevoir. Cela peut même ne pas apparaître très clairement au début de la conception et provoquer des pertes de temps au moment de l'étude du circuit spécifique. Ce cas se présente notamment lorsqu'on découvre que la complexité des tâches à faire exécuter par un microprocesseur nécessite au bout du compte une définition d'une valeur de temporisation avec par exemple plus de bits que n'en comporte la valeur de temporisation normale de la famille de microprocesseurs étudiés. Une valeur de temporisation est une suite de bits qui conditionne les diverses opérations effectuées par un microprocesseur au cours d'un cycle de travail.

Une des particularités des microprocesseurs connus actuellement est qu'ils ne sont pas multitâches. En effet, le fonctionnement actuel des microprocesseurs indépendants est organisé autour du concept de niveau d'interruption. Une tâche de niveau d'interruption donné sera toujours exécutée jusqu'à son terme de préférence à une tâche de niveau d'interruption inférieure. En pratique, lorsque le microprocesseur effectue une tâche de niveau subalterne et qu'il est confronté à l'exécution d'une tâche de niveau hiérarchique supérieure, il interrompt la tâche subalterne au profit de l'exécution de la tâche supérieure. La tâche subalterne est ensuite reprise, là où elle en était de son développement, à l'issue de l'exécution de la tâche supérieure. Le fonctionnement dans ce cas du microprocesseur n'est pas multitâches mais plutôt en temps partagé.

Dans un exemple auquel on se référera par la suite, on considère, dans le domaine de la domotique, l'envoi sur un réseau de distribution électrique, en courant porteur, de signaux de commande et/ou de signalisation. Compte tenu des différents protocoles existants, il est connu de placer dans chaque appareil ainsi connecté au réseau d'alimentation électrique un contrôleur de bits. En mode réception, le contrôleur de bits vérifie que la présentation des bits reçus est conforme à un protocole établi. En mode émission, le contrôleur de bits vérifie que les bits que l'appareil est en train d'émettre sont également émis conformément à ce protocole. Dans une première demande de brevet français déposée le 30 avril 1992 sous le n° 92 05423, le présent demandeur a prévu de faire exécuter ce contrôle de bits par le microprocesseur de l'appareil. Dans une autre demande de brevet français n° 92 15039 déposée le 14 décembre 1992, le même demandeur a prévu un circuit spécifique à microprocesseur capable d'assurer l'interface entre l'appareil et le réseau de distribution électrique, donc le contrôle de bits. Dans les deux cas, au moment de l'émission, les microprocesseurs doivent gérer l'émission du message ainsi que le contrôle du message émis. Il s'agit donc dans ce cas d'exécuter les tâches qui sont simultanées.

Compte tenu des vitesses et des débits en jeu, il est possible de choisir des microprocesseurs rapides de façon à traiter en temps partagé chacune de ces tâches pour donner l'impression que chacune est exécutée en même temps que l'autre. Ceci n'est pas toujours possible si ce n'est au prix d'un microprocesseur rapide, donc en principe plus cher.

Dans le cas où cela n'est pas possible, il convient de trouver dans le cadre de la technologie existante un circuit spécifique, à microprocesseur dédié, qui remplisse les fonctions demandées dont certaines peuvent être simultanées. Dans le domaine de la domotique le nombre de ces circuits à concevoir est très grand.

Le document MICROPROCESSING AND MICROPROGRAMMING, vol.24, no.1-5, 29 Août 1988, NORTH-HOLLAND pages 299-306; RAMMIG ET AL:"A transputer-based accelerator for multilevel digital simulation" concerne l'utilisation de transputers pour la simulation des circuits décrit en langage DACAPO (hardware description language).

L'invention vise à faciliter la conception de ces circuits et à mettre à la disposition des concepteurs un outil de travail leur permettant d'identifier rapidement les conflits de ressources (saturation du microprocesseur, ou des bus de données, d'adresses, ou de commande) et d'évaluer dans quelle mesure certaines parties d'un circuit devront être réalisées sous forme matérielle (circuit câblé) au lieu d'être réalisées sous forme de logiciel avec un circuit à microprocesseur seul.

Pour résoudre ces problèmes, dans l'invention on simule la fonction à réaliser par le circuit spécialisé à concevoir essentiellement avec une machine à architecture parallèle, munie dans un exemple de transputers. Une machine à architecture parallèle munie de transputers est une machine très puissante comportant dans son principe plusieurs microprocesseurs, chaque microprocesseur étant capable d'exécuter toutes les tâches qu'on peut lui confier. La machine à architecture parallèle possède en outre un circuit programmateur propre qui distribue les tâches à ceux des microprocesseurs qui lui paraissent les plus aptes à les exécuter : en pratique ceux qui sont disponibles, ou ceux qui en sont les plus près compte tenu de leur répartition sur le circuit intégré du transputer. Ce faisant, on est sûr que la totalité des tâches à exécuter pourra être exécutée compte tenu de la puissance de la machine à architecture parallèle.

Dans l'invention on relève alors toutes les opérations de distribution effectuées par le circuit programmateur, notamment leur début et leur fin ainsi que la désignation du microprocesseur choisi par le circuit programmateur afin de constituer une liste d'exécution. En consultant cette liste, le concepteur de circuit intégré spécifique peut ensuite évaluer plus rapidement quel est le circuit qui sera le plus adapté pour effectuer l'ensemble de l'application. Le circuit ASIC ainsi choisi pourra être adapté en taille et en coût à l'application envisagée. La liste d'exécution indique pour chaque tâche la durée d'utilisation de chacun des microprocesseurs. La somme de ces durées doit par exemple être inférieure à la durée de la tâche si on veut choisir un circuit spécifique à microprocesseur unique.

L'invention a donc pour objet un procédé de détermination de la composition d'un circuit intégré de type ASIC muni d'une unité arithmétique et ou logique, d'une mémoire programme non volatile, et d'un ou de plusieurs registres de travail, comportant les étapes suivantes:
- on établit une liste des tâches à faire exécuter avec le circuit intégré à déterminer,
- pour une application donnée dans un environnement donné, une tâche consistant à recevoir des signaux numériques fournis par des circuits dits amonts du circuit intégré de type ASIC ou extérieurs à celui-ci, à traiter les signaux reçus, et à délivrer des signaux traitées à des circuits dits avals de ce circuit intégré de type ASIC ou extérieurs à celui-ci,
- on organise ces tâches entre elles en un programme informatique,

caractérisé en ce que
- on simule l'exécution de ces tâches dans une machine à architecture parallèle, dite à transputers, comportant un circuit programmateur relié à un certain nombre de circuits à microprocesseurs pour leur faire exécuter des tâches, ce circuit programmateur recevant, en provenance des circuits dits amonts, des requêtes en exécution de tâches à exécuter, ce circuit programmateur choisissant pour l'exécution de chaque tâche celui des circuits à microprocesseur le plus apte à exécuter la tâche, ce circuit programmateur faisant ensuite exécuter cette tâche par ce circuit à microprocesseur et transmettre les données traitées aux circuits dits avals,
- on relève la chronologie et la durée d'exécution des tâches distribuées par le circuit programmateur, dans le but d'examiner cette chronologie et cette durée, notamment d'examiner à quel moment dans cette exécution des tâches il peut y avoir un conflit de ressources de traitement, afin de déterminer la nature du circuit intégré de type ASIC à réaliser.

L'invention a également pour objet un dispositif de détermination de la composition d'un circuit intégré de type ASIC destiné à être muni d'une unité arithmétique et ou logique, d'une mémoire programme non volatile, et d'un ou de plusieurs registres de travail, caractérisé en ce qu'il comporte:
- une mémoire comportant une liste des tâches à faire exécuter avec le circuit intégré à déterminer,
- des ports d'entrée pour recevoir des signaux numériques fournis par des circuits dits amonts du circuit intégré de type ASIC ou extérieurs à celui-ci,
- une machine à architecture parallèle, dite à transputers, comportant un circuit programmateur relié à un certain nombre de circuits à microprocesseurs pour leur faire exécuter des tâches, ce circuit programmateur recevant, en provenance des circuits dits amonts, des requêtes en exécution de tâches à exécuter,
- des ports de sortie pour transmettre des signaux numériques traités à des circuits dits avals de ce circuit intégré de type ASIC ou extérieurs à celui-ci,
- un microprocesseur dédié à l'enregistrement des origines des dates de requêtes en exécution de tâches à exécuter, des désignations des microprocesseurs les plus aptes à exécuter ces tâches choisis par le circuit programmateur, et des dates de fins d'exécution constatées par la transmission des données traitées aux circuits dits avals.

L'invention sera mieux comprise à la lecture de la description qui suit à l'examen des figures qui l'accompagnent. Celles-ci ne sont données qu'à titre indicatif et nullement limitatif de l'invention. Les figures montrent :
- figure 1 : une représentation schématique d'un dispositif utilisable pour mettre en oeuvre le procédé de l'invention;
- figure 2 : une représentation fonctionnelle d'un exemple de configuration d'une machine à architecture parallèle pour faire effectuer un certain nombre de tâches par les microprocesseur de la machine.

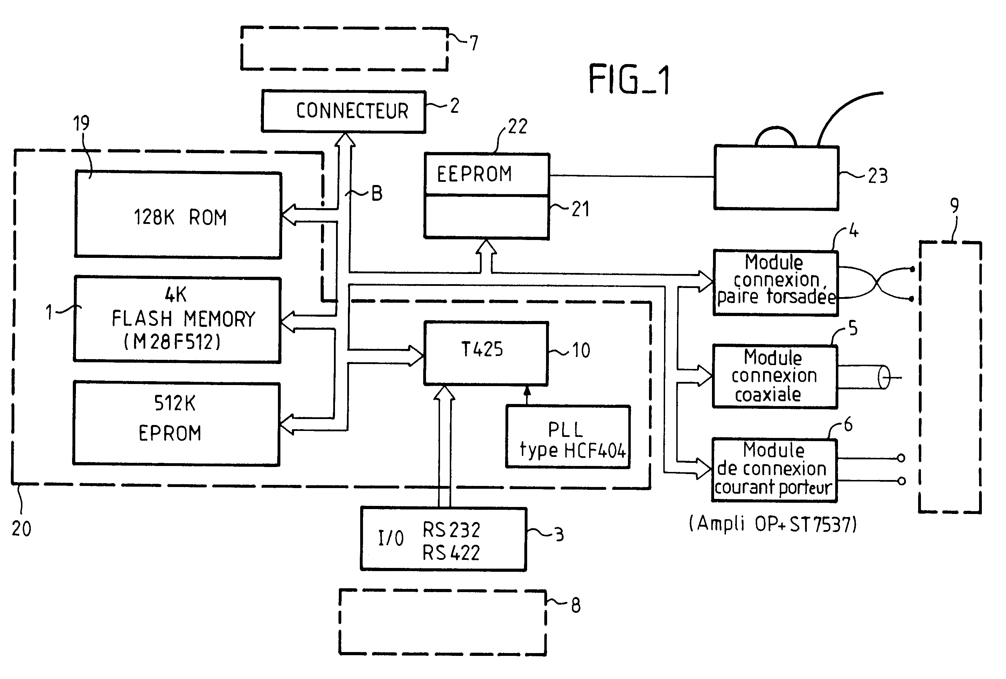

La figure 1 montre un dispositif de détermination conforme à l'invention. Une mémoire 1 comporte une liste des tâches à faire exécuter par le circuit intégré à déterminer. Cette liste est par exemple constituée en un programme informatique écrite de préférence en langage C et destinée à être mise en oeuvre selon Military Standard IEEE dit VHDL (Very Hierarchical Description Language) édité sous le n° 454 en 1984 par les autorités militaires américaines. Ce langage est dérivé du langage ADA, a été normalisé en France en 1988 dans le but de conduire à la détermination des circuits intégrés de type ASIC. Un langage de type VHDL est par exemple mis en oeuvre dans le logiciel "CADENCE" produit par la société CADENCE, Etats-Unis d'Amérique, et dans un autre logiciel dit MONTOR d'origine américaine également. Pour une utilisation donnée, une application, on sait donc déjà constituer en un programme les instructions nécessaires.

Le dispositif de l'invention comporte également des ports tels que 2 à 6 servant de port d'entrée ou de port de sortie. Le port 2 est par exemple un connecteur de type classique comportant, d'une manière différenciée, d'un bus de commandes, d'un bus de données, un bus d'adresses et un bus de contrôle. Le port 3 est une interface de type RS232 ou RS422 avec son protocole intégré de conversion pour transmettre tous les signaux utiles sur un nombre réduit de fils. Les ports 4, 5 et 6 sont des ports spécialisés à une connexion du circuit respectivement à des dispositifs de transmission par paires torsadés, connexion coaxiale, ou courant porteur. On peut envisager d'autres types de port, notamment pour des transmissions hertziennes ou par fibre optique.

Ces ports permettent de relier des circuits amonts tels que 7 à 9 au circuit intégré. Dans le cas où le circuit intégré à concevoir est relatif à un moteur, un circuit amont sera par exemple un ampèremètre de mesure du débit du courant passant dans le moteur, ou numériques une génératrice tachymétrique couplée au moteur et délivrant des signaux numériques. Le circuit de la figure 1 va simuler le traitement des signaux qu'il reçoit ainsi de ces circuits amont 7 à 9 en application du programme continu dans la mémoire 1. Il va ensuite transmettre les signaux traités à des circuits avals, ici en l'occurrence d'autres circuits 7 à 9. Par exemple, le circuit aval peut être le circuit 8 et le circuit amont le circuit 9 ou vice versa.

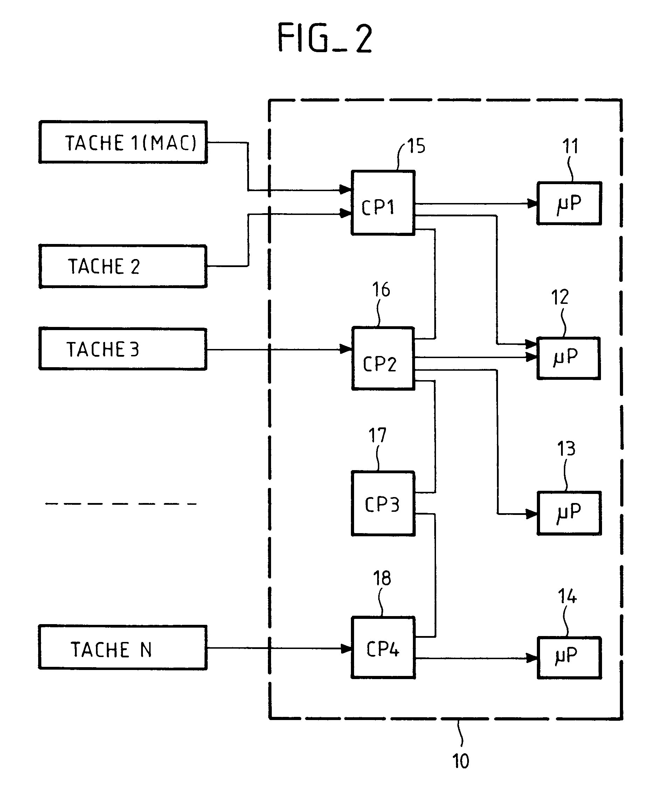

Pour simuler les tâches, le dispositif de l'invention comporte une machine à architecture parallèle constituée par un transputer, par exemple un transputer de type T425 fourni par la société INMOS, Angleterre. Ce transputer 10, ces circuits de port 2-6, et les différentes mémoires du circuit sont reliés ensemble par un bus général B. La figure 2 montre le principe de fonctionnement d'un transputer de ce type. Un tel transputer 10 comporte un certain nombre microprocesseurs 11 à 15 susceptibles d'effectuer un certain nombre de tâches : de recevoir des signaux numériques, de les traiter, et de les transmettre une fois leur traitement effectué. Ces circuits sont sous la dépendance d'un ou plusieurs circuits programmateurs (SCHEDULER) respectivement 15 à 18 chargés d'affecter l'exécution d'une tâche à l'un ou l'autre des microprocesseurs.

Par exemple dans sa définition, un circuit programmateur 16 peut faire exécuter les tâches qui lui sont soumises par le microprocesseur 12 ou par le microprocesseur 13. Chacun de ces microprocesseurs constitue une ressource de la machine à architecture parallèle. Les circuits programmateurs 15 à 18 allouent ces ressources à l'exécution des différentes tâches. Cette allocation prend date à un moment donné et dure jusqu'à ce que la tâche soit exécutée par le microprocesseur concerné. On trouvera toute la documentation relative à ces machines à architecture parallèle dans les notices des transputers vendus par la société citée ci-dessus. Le programme qui permet le fonctionnement des circuits programmateurs 15 à 18 est contenu dans une mémoire programme 19 (figure 1).

Dans l'invention on a ajouté à une carte électronique 20 représentée sur la figure 1 et comportant un transputer 10 muni de son environnement, un microprocesseur supplémentaire 21 chargé de la surveillance des ordres transmis par les circuits programmateurs 15 à 18, ou par un circuit programmateur général. Le microprocesseur est aussi relié au bus B.

Pour l'exécution d'une tâche, une tâche 1, un circuit extérieur, par exemple un circuit dit MAC (Medium Acces Control) comportant un contrôleur de bits évoqué précédemment, envoie une indication au circuit programmateur 15 pour signaler son aptitude à émettre un message sur une ligne d'un réseau à courant porteur, par exemple pour passer au travers d'un module de connexion 6. Pour une première partie de la tâche 1 le circuit programmateur 15 va confier au microprocesseur 11 la mission d'établir la séquence des ordres nécessaires pour transférer le contenu d'une mémoire de données du circuit MAC à un modulateur connecté au module 6, et pour mettre en oeuvre ce modulateur afin de moduler le signal numérique avant son couplage à la ligne à courant porteur. Quasiment en même temps, le circuit programmateur 15 va recevoir une autre indication, en provenance du contrôleur de bits du modulateur, signalant que ce dernier a détecté la présence sur la ligne à courant porteur du signal émis. Ce signal émis est donc contrôlé. C'est une deuxième partie de la tâche 1.

Le circuit programmateur 15 sait à tout moment où en sont les ressources qu'il a allouées : si elles sont disponibles ou occupées. Avec la suite des instructions transmises au microprocesseur 11 (à charge pour ce dernier de les faire exécuter), le circuit programmateur 15 peut évaluer la disponibilité du microprocesseur 11. Pour l'exécution du contrôle de bits, le circuit programmateur 11 peut alors confier au même microprocesseur 11, ou à un autre microprocesseur 12, l'exécution des différentes instructions qui conduisent à cette fonction de contrôle de bits.

Ainsi de suite, pour une opération donnée, la machine à architecture parallèle avec ses circuits programmateurs et ses microprocesseurs est capable d'effectuer sans difficulté toutes les tâches qui lui sont confiées. Ceci est toujours possible car la machine 10 est très puissante. Au besoin, on choisit même un transputer plus puissant.

Avec le microprocesseur 21 on surveille les bus de contrôle du ou des circuits programmateurs 15 à 18 et on détecte l'origine des sollicitations, par exemple provenant de la demande d'émission ou du contrôle de bits. Les dates et les origines de ces requêtes sont mémorisées dans une mémoire 22, par exemple de type EEPROM qui lui est directement couplée. Le microprocesseur 21 enregistre également dans la mémoire 22, avec les dates de début et les natures des tâches démarrées, la désignation du microprocesseur, 11 ou 12, allouée par le circuit programmateur 15 à l'exécution de la tâche. Après réception, à l'issue de l'exécution des tâches, les circuits extérieurs envoient des signaux numériques servant d'accusés de réception. Ces accusés de réception sont gérés par la machine à architecture parallèle. Les accusés de réception servent notamment de constatation, pour le microprocesseur 21, de fin de la tâche concernée.

Une fois que la tâche a été effectuée, on peut provoquer, avec une imprimante 23, l'impression de la liste mémorisée en mémoire 22. A partir de cette liste, le concepteur de circuit peut ensuite choisir le circuit qu'il veut faire réaliser. Il dispose de beaucoup plus d'informations sans avoir fait aucune hypothèse restrictive.

En variante, plutôt que de prévoir un microprocesseur 21 spécifique, on choisira de confier à la machine 10 à architecture parallèle, une tâche supplémentaire : celle consistant à surveiller les directives données par le ou les circuits programmateurs 15-18. Dans ce cas, un des microprocesseurs, le microprocesseur 14 par exemple, peut être chargé de cette tâche spécifique : tâche N, figure 2. Dans ce cas, la solution matérielle avec le microprocesseur 21 est remplacée par une solution logicielle : la mémoire 1 comporte un complément de programme relatif aux mémorisations des directives à effectuer.

## Revendications

1. Procédé de détermination de la composition d'un circuit intégré de type ASIC muni d'une unité arithmétique et ou logique, d'une mémoire programme non volatile, et d'un ou de plusieurs registres de travail, comportant les étapes suivantes :
- on établit une liste des tâches à faire exécuter avec le circuit intégré à déterminer,
- pour une application donnée dans un environnement donné, une tâche consistant à recevoir des signaux numériques fournis par des circuits dits amonts du circuit intégré de type ASIC ou extérieurs à celui-ci, à traiter les signaux reçus, et à délivrer des signaux traitées à des circuits dits avals de ce circuit intégré de type ASIC ou extérieurs à celui-ci,
- on organise ces tâches entre elles en un programme informatique,
caractérisé en ce que
- on simule l'exécution de ces tâches dans une machine à architecture parallèle, dite à transputers, comportant un circuit programmateur relié à un certain nombre de microprocesseurs pour leur faire exécuter des tâches, ce circuit programmateur recevant, en provenance des circuits dits amonts, des requêtes en exécution de tâches à exécuter, ce circuit programmateur choisissant pour l'exécution de chaque tâche le microprocesseur le plus apte à exécuter la tâche, ce circuit programmateur faisant ensuite exécuter cette tâche par ce microprocesseur et transmettre les données traitées aux circuits dits avals,
- on relève la chronologie et la durée d'exécution des tâches distribuées par le circuit programmateur, dans le but d'examiner cette chronologie et cette durée, notamment d'examiner à quel moment dans cette exécution des tâches il peut y avoir un conflit de ressources de traitement, afin de déterminer la nature du circuit intégré de type ASIC à réaliser.

2. Procédé selon la revendication 1, caractérisé en ce que pour relever la chronologie et la durée d'exécution des tâches distribuées par le circuit programmateur,
- on enregistre avec un microprocesseur dédié à cette tâche, les origines et les dates de requêtes en exécution de tâches à exécuter, les désignations des microprocesseurs les plus aptes à exécuter ces tâches choisis par le circuit programmateur et les dates de fins d'exécution constatées par la transmission des données traitées aux circuits dits avals,
- et on édite ces enregistrements.

3. Dispositif de détermination de la composition d'un circuit intégré de type ASIC destiné à être muni d'une unité arithmétique et ou logique, d'une mémoire programme non volatile, et d'un ou de plusieurs registres de travail, caractérisé en ce qu'il comporte:
- une mémoire (1) comportant une liste des tâches à faire exécuter avec le circuit intégré à déterminer,
- des ports (2-6) d'entrée pour recevoir des signaux numériques fournis par des circuits (7-9) dits amonts du circuit intégré de type ASIC ou extérieurs à celui-ci,
- une machine (10)à architecture parallèle, dite à transputers, comportant un circuit programmateur (15) relié à un certain nombre de microprocesseurs (11-14) pour leur faire exécuter des tâches, ce circuit programmateur recevant, en provenance des circuits dits amonts, des requêtes en exécution de tâches à exécuter,
- des ports (2-6) de sortie pour transmettre des signaux numériques traités à des circuits dits avals (7-9) de ce circuit intégré de type ASIC ou extérieurs à celui-ci,
- un microprocesseur (21) dédié à l'enregistrement des origines des dates de requêtes en exécution de tâches à exécuter, des désignations des microprocesseurs les plus aptes à exécuter ces tâches choisis par le circuit programmateur, et des dates de fin d'exécution constatées par la transmission des données traitées aux circuits dits avals.

4. Dispositif selon la revendication 3, caractérisé en ce que
- le microprocesseur dédié à l'enregistrement est un des microprocesseurs (14) de la machine à architecture parallèle.

## Patentansprüche

1. Verfahren zum Bestimmen des Aufbaus einer anwendungsspezifischen integrierten Schaltung (ASIC) mit einer Arithmetik- und/oder Logikeinheit, einem nichtflüchtigen Programmspeicher und einem oder mehreren Arbeitsregistern, mit folgenden Schritten:
- Aufstellen einer Liste der von der zu bestimmenden integrierten Schaltung auszuführenden Aufgaben,
- wobei bei gegebener Anwendung und gegebener Umgebung eine Aufgabe darin besteht, numerische Signale von Schaltungen zu empfangen, die stromaufwärts von der anwendungsspezifischen integrierten Schaltung oder außerhalb dieser liegen, die empfangenden Signale zu bearbeiten und die bearbeiteten Signale an Schaltungen abzugeben, die stromabwärts von der anwendungsspezifischen integrierten Schaltung oder außerhalb dieser liegen,
- Zusammenstellen dieser Aufgaben zu einem Informatikprogramm,
**dadurch gekennzeichnet** daß
- die Ausführung dieser Augaben in einem Parallelrechner oder Transputer simuliert wird, der eine Programmierschaltung umfaßt, die mit einer bestimmten Anzahl von Mikroprozessoren verbunden ist, um diese zu veranlassen, die Aufgaben auszuführen, wobei diese Programmierschaltung von den stromaufwärtigen Schaltungen Anforderungen zur Ausführung von auszuführenden Aufgaben empfängt, zur Ausführung einer jeden Aufgabe den zur Ausführung dieser Aufgabe am besten geeigneten Mikroprozessor auswählt, anschließend veranlaßt, daß dieder die Aufgabe ausführt und daß die bearbeiteten Daten an die stromabwärtigen Schaltungen ausgegeben werden,
- der zeitliche Ablauf und die Dauer der Ausführung der von der Programmierschaltung verteilten Aufgaben ermittelt wird, um diesen zeitlichen Ablauf und diese Dauer zu untersuchen, insbesondere, um zu untersuchen, zu welchem Zeitpunkt bei dieser Ausführung der Aufgaben ein Bearbeitungsressourcenkonflikt auftreten kann, um so die Art der zu realisierenden anwendungsspezifischen integrierten Schaltung zu bestimmen.

2. Verfahren nach Anspruch 1, dadurch gekennzeichnet, daß zum Ermitteln des zeitlichen Ablaufs und der Dauer der Ausführung der von der Programmierschaltung verteilten Aufgaben
- mit einem für diese Aufgabe vorgesehenen Mikroprozessor Herkunft und Daten von Anforderungen zur Ausführung von auszuführenden Aufgaben, die Bezeichnungen der von der Programmierschaltung ausgewählten, zur Ausführung dieser Aufgaben am besten geeigneten Mikroprozessoren und die durch die Übertragung der bearbeiteten Daten an die stromabwärtigen Schaltungen festgestellten Bearbeitungsbeendigungsdaten aufgezeichnet werden und
- diese Aufzeichnungen editiert werden.

3. Vorrichtung zur Bestimmung des Aufbaus einer anwendungsspezifischen integrierten Schaltung, die mit einer Arithmetik- und/oder Logikeinheit, einem nichtfluchtigen Programmspeicher und einem oder mehreren Arbeitsregistern versehen werden soll, gekennzeichnet durch:
- einen Speicher (1) mit einer Liste der von der zu bestimmenden integrierten Schaltung auszuführenden Aufgaben,
- Eingangsanschlüssen (2-6) zum Empfangen von numerischen Signalen, die von Schaltungen (7-9) geliefert werden, die stromaufwärts von der anwendungsspezifischen integrierten Schaltung oder außerhalb dieser liegen,
- einem Parallelrechner oder Transputer (10) mit einer Programmierschaltung (15), die mit einer bestimmten Zahl von Mikroprozessoren (11-14) verbunden ist, um diese zu veranlassen, Aufgaben auszuführen, wobei diese Programmierschaltung von den stromaufwärtigen Schaltungen Anforderungen zur Ausführung von auszuführenden Aufgaben empfängt,
- Ausgangsanschlüssen (2-6) zum Übertragen von bearbeiteten numerischen Signalen an Schaltungen (7-9), die stromabwärts von der anwendungsspezifischen integrierten Schaltung oder außerhalb dieser liegen,
- einem Mikroprozessor (21), der vorgesehen ist zum Aufzeichnen der Herkunft der Daten von Anforderungen zur Ausführung von auszuführenden Aufgaben, der Bezeichnungen der von der Programmierschaltung ausgewählten, zur Ausführung dieser Aufgaben am besten geeigneten Mikroprozessoren und der durch die Übertragung der bearbeiteten Daten an die stromabwärtigen Schaltungen festgestellten Ausführungsbeendigungsdaten.

4. Vorrichtung nach Anspruch 3, dadurch gekennzeichnet, daß der zum Aufzeichnen vorgesehene Mikroprozessor einer der Mikroprozessoren (14) des Parallelrechners ist.

## Claims

1. Method for determining the composition of an integrated circuit of the ASIC type provided with an arithmetic and/or logic unit, a non-volatile program memory, and one or more working registers, including the following steps:
- a list of tasks to be executed with the integrated circuit to be determined is established,
- for a given application in a given environment, a task consisting of receiving digital signals supplied by so-called upstream circuits of the ASIC-type integrated circuit or circuits external to the latter, processing the signals received, and delivering processed signals to so-called downstream circuits of from this ASIC-type integrated circuit or circuits external to the latter,
- these tasks are organized together in a computer program, characterised in that
- the execution of these tasks is simulated in a parallelarchitecture machine of the so-called transputer type, including a programming circuit connected to a certain number of microprocessors in order to make them execute tasks, this programming circuit receiving, originating from the so-called upstream circuits, execution requests for the tasks to be executed, this programming circuit choosing, for the execution of each task, the microprocessor most suitable for executing the task, this programming circuit then causing this task to be executed by this microprocessor and the processed data to be transmitted to the so-called downstream circuits,
- the chronology and duration of the execution of the tasks distributed by the programming circuit are recorded, with the aim of examining this chronology and this duration, notably of examining at which moment in this execution of the tasks there might be a conflict of processing resources, in order to determine the nature of the ASIC-type integrated circuit to be produced.

2. Method according to Claim 1, characterised in that, in order to record the chronology and duration of the execution of the tasks distributed by the programming circuit,
- the origins and dates of requests for the execution of tasks to be executed, the designations of the microprocessors most suitable for executing these tasks chosen by the programming circuit and the end-of-execution times recorded by the transmission of the processed data to the so-called downstream circuits are stored using a microprocessor dedicated to this task,
- and this stored information is edited.

3. Device for determining the composition of an integrated circuit of the ASIC type designed to be provided with an arithmetic and/or logic unit, a non-volatile program memory, and one or more working registers, characterised in that it includes:
- a memory (1) including a list of tasks to be performed with the integrated circuit to be determined,
- input ports (2-6) for receiving digital signals supplied by so-called upstream circuits (7-9) of the ASIC-type integrated circuit or circuits external to the latter,
- a parallel-architecture machine (10) of the so-called transputer type, having a programming circuit (15) connected to a certain number of microprocessors (11-14) in order to make them execute tasks, this programming circuit receiving execution requests for the tasks to be executed, originating from the so-called upstream circuits,
- output ports (2-6) for transmitting processed digital signals to so-called downstream circuits (7-9) of this ASIC-type integrated circuit or circuits external to the latter,
- a microprocessor (21) dedicated to storing the origins of the times of requests for the execution of tasks to be executed, the designations of the microprocessors most suitable for executing these tasks chosen by the programming circuit, and the end-of-execution times recorded by the transmission of the processed data to the so-called downstream circuits.

4. Device according to Claim 3, characterised in that
- the microprocessor dedicated to storage is one of the microprocessors (14) of the parallel-architecture machine.
